# FASCICULE DE BREVET EUROPEEN

(11) **EP 1 006 532 B1**
(45) Date de publication et mention de la délivrance du brevet: **21.01.2004**
(21) Numéro de dépôt: 99460065.8
(22) Date de dépôt: 26.11.1999
(51) Int. Cl.: G11C 16/06

(54) **Mémoire EEPROM sécurisée comportant des moyens de détection d'effacement par UV**
Sicherer EEPROM-Speicher mit UV-Lösch-Erkennungsmitteln
Secure EEPROM with UV erasure detection means

(30) Priorité: 02.12.1998 FR 9815447
(43) Date de publication de la demande: 07.06.2000
(73) Titulaire: STMicroelectronics S.A., 92120 Montrouge (FR)
(72) Inventeur: Chehadi, Mohamad, 56100 Lorient (FR)
(74) Mandataire: Bentz, Jean-Paul

(56) Documents cités:
- EP-A- 0 300 885
- EP-A- 0 417 008
- EP-A- 0 874 369
- WO-A-83/00254
- FR-A- 2 567 302

## Description

La présente invention concerne une mémoire non volatile modifiable électriquement sécurisée comportant des moyens pour détecter si elle a été effacée par exposition à un rayonnement ultraviolet.

On entend par mémoire EEPROM sécurisée, toute mémoire dont l'accès en écriture est limité de manière à protéger son contenu. La protection peut être soit logicielle, soit matérielle. Ce type de mémoire EEPROM est notamment protégé contre l'effacement électrique de ses cellules.

Une technique imaginée par certains fraudeurs pour contourner la protection contre l'effacement électrique, consiste à effectuer un effacement par rayonnement ultraviolet (UV) bien que ces mémoires soient théoriquement protégées par leur boîtier contre un tel effacement. En effet, ils ouvrent le boîtier de la mémoire pour accéder à son plan mémoire et modifient l'état des cellules de la mémoire en les exposant à un rayonnement ultraviolet. Cet effacement frauduleux ne stoppe pas forcément l'exécution de l'application dans laquelle la mémoire est utilisée et la fraude n'est donc pas forcément détectée.

Le but de l'invention est de proposer une mémoire EEPROM sécurisée permettant de détecter cette fraude et de savoir si les cellules de la mémoire ont été soumises à un rayonnement ultraviolet.

Aussi, l'invention a pour objet une mémoire non volatile modifiable électriquement sécurisée comportant une matrice de cellules mémoire et des moyens de lecture et d'écriture desdites cellules mémoire, ladite mémoire étant caractérisée en ce qu'elle comporte en outre au moins une cellule mémoire supplémentaire, appelée cellule témoin, et des moyens de lecture associés aptes à détecter si ladite cellule témoin a été effacée par un rayonnement ultraviolet en ce qu'à chaque accès à la mémoire, la cellule témoin est lue par lesdits moyens de lecture associés.

Dans sa version la plus simple, la mémoire EEPROM sécurisée de l'invention comporte une cellule témoin unique.

Selon un premier mode de réalisation de l'invention, la cellule témoin est initialement dans un état électrique effacé et, pour détecter si ladite cellule témoin a été effacée par un rayonnement ultraviolet, lesdits moyens de lecture associés présentent un seuil de détection dont la valeur est comprise entre la valeur de seuil de conduction d'une cellule effacée électriquement et la valeur de seuil de conduction d'une cellule effacée par rayonnement ultraviolet.

Selon un second mode de réalisation de l'invention, la cellule témoin est initialement dans un état électrique programmé et, pour détecter si ladite cellule témoin a été effacée par un rayonnement ultraviolet, lesdits moyens de lecture associés présentent un seuil de détection dont la valeur est comprise entre la valeur de seuil de conduction d'une cellule programmée électriquement et la valeur de seuil de conduction d'une cellule effacée par rayonnement ultraviolet.

Alors, si l'état de la cellule témoin détecté par les moyens de lecture associés est différent de son état électrique initial, cela indique que la mémoire a été soumise à un rayonnement ultraviolet et le fonctionnement de la mémoire est alors neutralisé.

D'autres caractéristiques et avantages de l'invention apparaîtront à la lecture de la description détaillée qui suit et qui est faite en référence aux dessins annexés, parmi lesquels :
- la figure 1 représente un exemple de réalisation d'une mémoire EEPROM selon l'invention, et
- la figure 2 représente les seuils de conduction possibles d'une cellule mémoire et le seuil de détection des moyens de lecture de la cellule témoin selon l'invention.

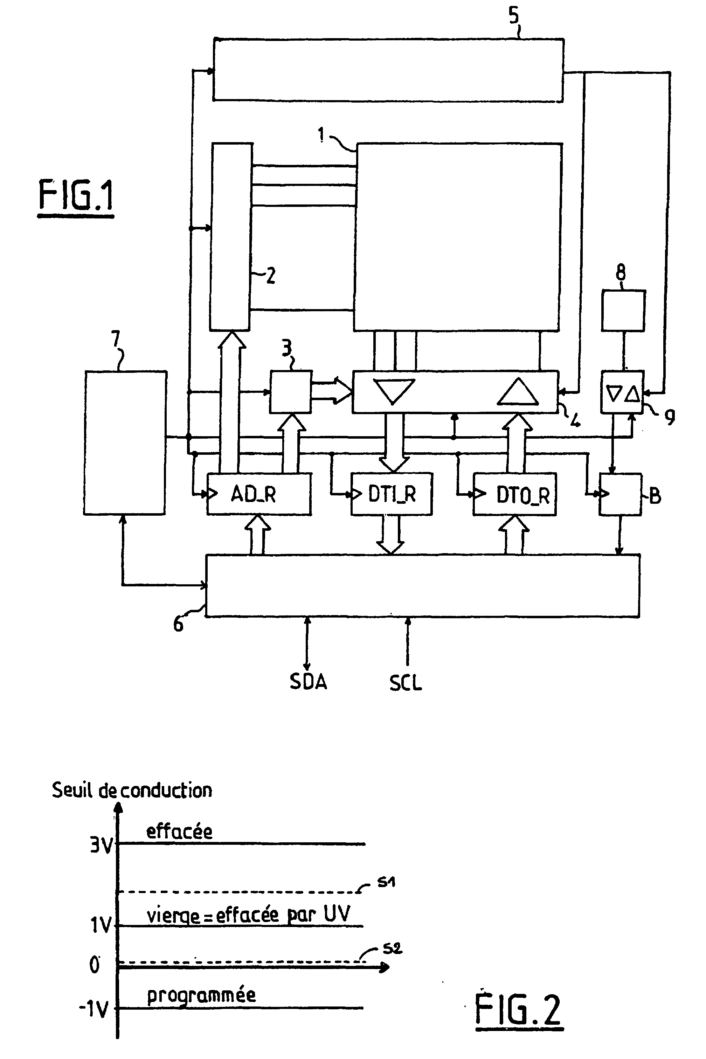

La mémoire EEPROM sécurisée illustrée à la figure 1 comprend une matrice principale 1 de cellules mémoire adressables par un décodeur de lignes 2 et un décodeur de colonnes 3. Le décodeur de colonnes 3 est associé à des circuits de lecture et d'écriture 4 des cellules de la matrice principale. Des moyens de programmation 5 sont prévus pour fournir les tensions nécessaires à l'écriture des cellules de la mémoire. Les décodeurs de lignes 2 et de colonnes 3 sont reliés à un registre d'adresses AD_R. Les circuits de lecture et d'écriture sont reliés à un registre de données d'entrée DTI_R et à un registre de données de sortie DTO_R. Ces trois registres communiquent avec un circuit d'interface 6.

Dans l'exemple représenté à la figure 1, le circuit d'interface 6 de la mémoire est relié à un bus I²C comprenant notamment une ligne d'horloge SCL et une ligne bidirectionnelle SDA pour véhiculer les adresses, les données et les commandes. L'ensemble est commandé par un circuit de commande 7. Il est réalisé par exemple sous la forme d'un réseau logique programmable (PLA) et est conçu pour fournir des signaux de commande à tous les éléments de la mémoire en fonction des commandes reçues par le circuit d'interface 6. Dans cet exemple, la mémoire est sécurisée par une protection logicielle mise en oeuvre dans le circuit de commande 7.

Les cellules de la matrice 1 peuvent prendre trois états électriques possibles illustrés figure 2:
- un état effacé, dans lequel la valeur du seuil de conduction des cellules est de 3 volts environ;
- un état programmé, dans lequel la valeur du seuil de conduction des cellules est de -1 volt environ;
- un état vierge, dans lequel la valeur du seuil de conduction des cellules est de 1 volt environ; c'est également l'état dans lequel se trouve une cellule mémoire qui a été effacée par un rayonnement ultraviolet.

Pour la mise en oeuvre de l'invention, le schéma de la mémoire est complété par une cellule mémoire supplémentaire 8, appelée cellule témoin. Des moyens de lecture et d'écriture 9 sont reliés à ladite cellule. Les moyens 9 sont commandés par le circuit de commande 7. Les moyens de lecture et d'écriture 9 comportent notamment un amplificateur de lecture (appelé "SENSE" dans la littérature anglo-saxonne) qui a pour rôle de comparer la valeur du seuil de conduction de la cellule témoin avec celle d'un seuil de détection de référence. L'amplificateur de lecture délivre un "0" si la valeur du seuil de conduction de la cellule lue est supérieure à celle du seuil de référence, sinon il délivre un "1".

La mémoire comporte en outre une bascule de sortie B dont l'entrée est connectée aux moyens de lecture et d'écriture 9 et dont la sortie est reliée au circuit d'interface 6.

La cellule témoin 8 peut être placée à la périphérie de la matrice principale 1 ou, encore mieux, au coeur de cette matrice pour rendre sa localisation plus difficile. Cette cellule témoin est initialement dans un état programmé ou effacé, cette opération de programmation ou d'effacement étant effectuée en usine par le fabricant de la mémoire ou par le client lors de la réalisation d'une application utilisant cette mémoire. La cellule témoin est ensuite protégée contre tout accès en écriture par le circuit de commande 7 comme les autres cellules de la matrice 1.

Avantageusement, on pourra également prévoir plusieurs cellules témoin réparties sur l'ensemble de la matrice principale 1 pour détecter toute exposition même partielle du plan mémoire à un rayonnement UV.

Selon l'invention, l'état de la cellule témoin lu par les moyens de lecture 9 doit permettre de détecter si la mémoire a subi un effacement par rayonnement ultraviolet depuis le dernier accès à la mémoire.

Ainsi, si la cellule témoin 8 est dans état initial effacé, on prévoit selon l'invention que le seuil de détection de l'amplificateur de lecture des moyens 9 ait une valeur comprise entre la valeur de seuil de conduction d'une cellule effacée électriquement et la valeur de seuil de conduction d'une cellule effacée par rayonnement ultraviolet. Ce seuil de détection est référencé S1 dans le diagramme de la figure 2. Il en résulte que, si les cellules de la mémoire n'ont pas été soumises à un rayonnement ultraviolet, la cellule témoin est restée dans son état initial effacé et les moyens 9 délivrent un "0" lors de la lecture de la cellule témoin. En revanche, si les cellules de la mémoire ont été effacées par ultraviolet, la cellule témoin est dans un état vierge et les moyens 9 délivrent un "1" lors de la lecture de cette cellule.

Dans le cas où la cellule témoin serait initialement dans un état programmé, on prévoit selon l'invention que le seuil de détection de l'amplificateur de lecture des moyens 9 ait une valeur comprise entre la valeur de seuil de conduction d'une cellule programmée électriquement et la valeur de seuil de conduction d'une cellule effacée par rayonnement ultraviolet. Ce seuil de détection est référencé S2 dans le diagramme de la figure 2. De cette façon, si les cellules de la mémoire ont été soumises à un rayonnement ultraviolet, la cellule témoin est dans un état vierge et les moyens 9 délivrent un "0", sinon ils délivrent un "1".

La cellule témoin 8 est lue à chaque accès mémoire. La valeur lue est ensuite mémorisée dans une bascule de sortie B dont l'entrée est reliée à la sortie des moyens de lecture 9 et dont la sortie est reliée au circuit d'interface 6. La mémorisation de la valeur lue par les moyens 9 dans la bascule B est déclenchée par le circuit de commande 7.

La valeur mémorisée dans la bascule de sortie B est ensuite traitée par le circuit de commande 7 de la mémoire. Elle est par exemple comparée à la valeur de référence, "0" ou "1", correspondant à la valeur initiale mémorisée par le fabricant dans la cellule témoin 8 ("0" pour une cellule effacée et "1" pour une cellule programmée). Si ces valeurs sont différentes, il y a eu exposition des cellules mémoire à un rayonnement ultraviolet et le fonctionnement du circuit de commande 7 est alors bloqué.

En variante, on peut prévoir de traiter la valeur mémorisée dans la bascule B par des circuits extérieurs à la mémoire, cette valeur leur étant transmise par l'intermédiaire du circuit d'interface 6. Ces circuits extérieurs sont par exemple les circuits nécessaires à la mise en oeuvre d'une application. Cette valeur est alors comparée dans ces circuits à la valeur initiale de la cellule témoin. Si les deux valeurs sont différentes, le déroulement de l'application est stoppé.

## Revendications

1. Mémoire non volatile effaçable et programmable électriquement, sécurisée, comportant une matrice de cellules mémoire (1) et des moyens de lecture et d'écriture (4) desdites cellules mémoire, ladite mémoire étant **caractérisée en ce qu'**elle comporte en outre au moins une cellule mémoire supplémentaire (8), ladite cellule étant appelée cellule témoin et étant initialement dans un état électrique effacé, et des moyens de lecture associés (9) pour lire la cellule témoin en comparant un seuil de conduction, mesuré de la cellule témoin (8) avec un seuil de détection des moyens de lecture (9) permettant de détecter si ladite cellule témoin a été effacée par un rayonnement ultraviolet, le dit seuil de détection (S1) étant compris entre le seuil de conduction d'une cellule effacée électriquement et le seuil de conduction d'une cellule effacée par rayonnement ultraviolet, et **en ce qu'**à chaque accès à la mémoire, la cellule témoin (8) est lue par lesdits moyens de lecture associés (9).

2. Mémoire non volatile effaçable et programmable électriquement, sécurisée, comportant une matrice de cellules mémoire (1) et des moyens de lecture et d'écriture (4) desdites cellules mémoire, ladite mémoire étant **caractérisée en ce qu'**elle comporte en outre au moins une cellule mémoire supplémentaire (8), la dite cellule etant appelée cellule témoin et étant initialement dans un état électrique programmé, et des moyens de lecture associés (9) pour lire la cellule témoin en comparant un seuil de conduction mesuré de la cellule témoin (8) avec un seuil de détection des moyens de lecture (9) permettant de détecter si ladite cellule témoin a été effacée par un rayonnement ultraviolet, le dit seuil de détection (S2) étant compris entre le seuil de conduction d'une cellule programmée électriquement et le seuil de conduction d'une cellule effacée par rayonnement ultraviolet, et **en ce qu'**à chaque accès à la mémoire, la cellule témoin (8) est lue par lesdits moyens de lecture associés (9).

3. Mémoire selon la revendication 1 ou 2, **caractérisée en ce qu'**elle comporte une seule cellule témoin (8).

4. Mémoire selon l'une des revendications 1 à 3, **caractérisée en ce qu'**elle comporte une bascule de sortie (B) dans laquelle le résultat de la lecture de la cellule témoin (8) est mémorisé.

5. Mémoire selon la revendication 4, **caractérisée en ce que**, si l'état de la cellule témoin (8) mémorisé dans la bascule de sortie est différent de son état initial, le fonctionnement de la mémoire est neutralisé.

## Patentansprüche

1. Nicht-flüchtiger, elektrisch lösch- und programmierbarer, sicherer Speicher, der eine Matrix aus Speicherzellen (1) und Lese- und Schreibeinrichtungen (4) dieser Speicherzellen aufweist, **dadurch gekennzeichnet, dass** er außerdem mindestens eine zusätzliche Speicherzelle (8), wobei diese Zelle Vergleichszelle genannt wird und sich ursprünglich in einem elektrisch gelöschten Zustand befindet, und zugeordnete Leseeinrichtungen (9) aufweist, um die Vergleichszelle (8) zu lesen, indem ein gemessener Leitungsschwellwert der Vergleichszelle (8) mit einem Erfassungsschwellwert der Leseeinrichtungen (9) verglichen wird, um feststellen zu können, ob die Vergleichszelle durch ultraviolette Strahlung gelöscht wurde, wobei der Erfassungsschwellwert (S1) zwischen dem Leitungsschwellwert einer elektrisch gelöschten Zelle und dem Leitungsschwellwert einer durch ultraviolette Strahlung gelöschten Zelle liegt, und dass bei jedem Zugriff auf den Speicher die Vergleichszelle (8) von den zugeordneten Leseeinrichtungen (9) gelesen wird.

2. Nicht-flüchtiger, elektrisch lösch- und programmierbarer, sicherer Speicher, der eine Matrix aus Speicherzellen (1) und Lese- und Schreibeinrichtungen (4) dieser Speicherzellen aufweist, **dadurch gekennzeichnet, dass** er außerdem mindestens eine zusätzliche Speicherzelle (8), wobei diese Zelle Vergleichszelle genannt wird und sich ursprünglich in einem elektrisch programmierten Zustand befindet, und zugeordnete Leseeinrichtungen (9) aufweist, um die Vergleichszelle (8) zu lesen, indem ein gemessener Leitungsschwellwert der Vergleichszelle (8) mit einem Erfassungsschwellwert der Leseeinrichtungen (9) verglichen wird, um feststellen zu können, ob die Vergleichszelle durch ultraviolette Strahlung gelöscht wurde, wobei der Erfassungsschwellwert (S2) zwischen dem Leitungsschwellwert einer elektrisch programmierten Zelle und dem Leitungsschwellwert einer durch ultraviolette Strahlung gelöschten Zelle liegt, und dass bei jedem Zugriff auf den Speicher die Vergleichszelle (8) von den zugeordneten Leseeinrichtungen (9) gelesen wird.

3. Speicher nach Anspruch 1 oder 2, **dadurch gekennzeichnet, dass** er eine einzige Vergleichszelle (8) aufweist.

4. Speicher nach einem der Ansprüche 1 bis 3, **dadurch gekennzeichnet, dass** er eine Ausgangskippstufe (B) aufweist, in der das Leseergebnis der Vergleichszelle (8) gespeichert wird.

5. Speicher nach Anspruch 4, **dadurch gekennzeichnet, dass** der Betrieb des Speichers neutralisiert wird, wenn sich der in der Ausgangskippstufe gespeicherte Zustand der Vergleichszelle (8) von ihrem ursprünglichen Zustand unterscheidet.

## Claims

1. Protected electrically erasable and programmable nonvolatile memory, comprising a matrix of memory cells (1) and means of reading and writing (4) the said memory cells, the said memory being **characterised in that** it also comprises at least one additional memory cell (8), the said cell being referred to as the reference cell and being initially in an erased electrical state, and associated reading means (9) for reading the reference cell by comparing a measured conduction threshold of the reference cell (8) with a detection threshold of the reading means (9) in order to detect whether the said reference cell has been erased by ultraviolet radiation, the said detection threshold (S1) lying between the conduction threshold of an electrically erased cell and the conduction threshold of a cell erased by ultraviolet radiation, and **in that**, at each access to the memory, the reference cell (8) is read by the said associated reading means (9).

2. Protected electrically erasable and programmable nonvolatile memory, comprising a matrix of memory cells (1) and means of reading and writing (4) the said memory cells, the said memory being **characterised in that** it also comprises at least one additional memory cell (8), the said cell being referred to as the reference cell and being initially in a programmed electrical state, and associated reading means (9) for reading the reference cell by comparing a measured conduction threshold of the reference cell (8) with a detection threshold of the reading means (9) in order to detect whether the said reference cell has been erased by ultraviolet radiation, the said detection threshold (S2) lying between the conduction threshold of an electrically programmed cell and the conduction threshold of a cell erased by ultraviolet radiation, and **in that**, at each access to the memory, the reference cell (8) is read by the said associated reading means (9).

3. Memory according to Claim 1 or 2, **characterised in that** it comprises a single reference cell (8).

4. Memory according to one of Claims 1 to 3, **characterised in that** it comprises an output flip flop (B) in which the result of the reading of the reference cell (8) is stored.

5. Memory according to Claim 4, **characterised in that**, if the state of the reference cell (8) stored in the output flip flop is different from its initial state, the functioning of the memory is neutralised.
